(19) Europäisches Patentamt
European Patent Office
Office européen des brevets

(11) **EP 2 687 860 B1**

(12) **FASCICULE DE BREVET EUROPEEN**

(45) Date de publication et mention
de la délivrance du brevet:
**23.03.2016   Bulletin 2016/12**

(51) Int Cl.:
***G01R 31/08*** *(2006.01)*          ***H02H 3/08*** *(2006.01)*

(21) Numéro de dépôt: **13172415.5**

(22) Date de dépôt: **18.06.2013**

(54) **Détection directionnelle de défaut terre sensible moyenne tension par corrélation linéaire**

Richtungs-Erkennung eines empfindlichen Mittelspannungs-Erdschlusses durch lineare Korrelation

Directional detection of a sensitive medium-voltage earth fault by linear correlation

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité:   **20.07.2012   FR 1257023**

(43) Date de publication de la demande:
**22.01.2014   Bulletin 2014/04**

(73) Titulaire: **Schneider Electric Industries SAS
92500 Rueil-Malmaison (FR)**

(72) Inventeurs:
• **Verneau, Guillaume
38050 GRENOBLE Cedex 09 (FR)**

• **Baumes, Nathalie
38050 GRENOBLE Cedex 09 (FR)**
• **Neveu, Thibault
38050 GRENOBLE Cedex 09 (FR)**

(74) Mandataire: **Colette, Marie-Françoise et al
Schneider Electric Industries SAS
Service Propriété Industrielle
WTC - E1
5, place Robert Schuman
38050 Grenoble Cedex 09 (FR)**

(56) Documents cités:
**FR-A1- 2 936 319**

**Description**

**DOMAINE TECHNIQUE**

L'invention concerne la détection de défaut sur un réseau électrique de distribution, notamment moyenne tension. En particulier, l'invention propose un principe de détection de défauts résistants entre un conducteur électrique moyenne tension et la terre, défaut par exemple causé par la rupture dudit conducteur, ainsi qu'un dispositif adapté. Des paramètres issus du traitement des seuls signaux représentatifs des courants de chaque phase du réseau permettent la localisation directionnelle, sans utiliser de valeurs représentatives de la tension entre phases, ni de valeurs représentatives des tensions simples.

L'invention concerne également un dispositif de signalisation de défaut et un relai de déclenchement comprenant des capteurs de courant associés à chaque phase du réseau et fournissant au dispositif de détection précédent les signaux permettant la signalisation, par exemple par voyant, ou le déclenchement d'un dispositif de coupure du réseau.

**ETAT DE LA TECHNIQUE**

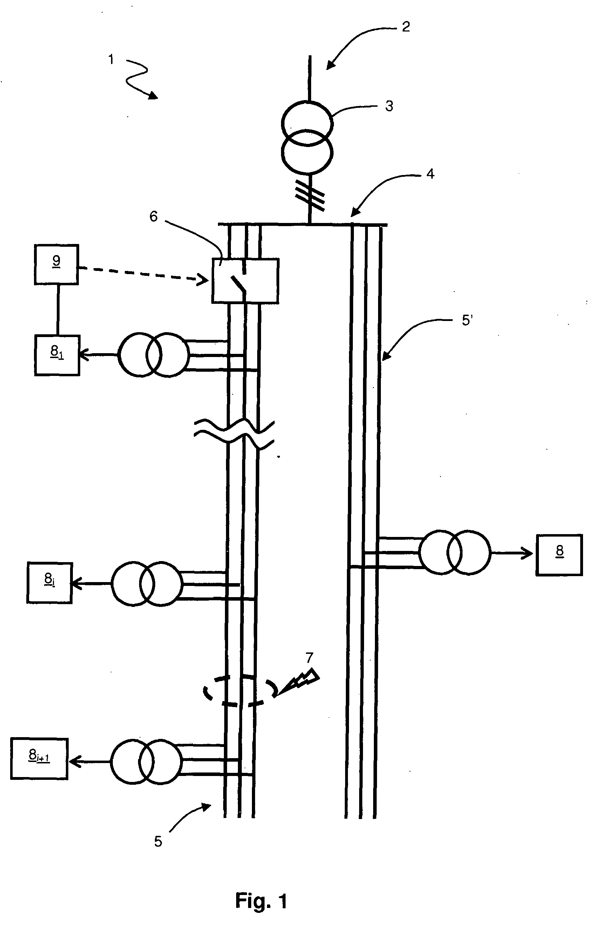

Les dispositifs de détection de défaut à la terre sont notamment utilisés dans les réseaux de distribution électrique triphasés moyenne tension. Tel qu'illustré en figure 1, les réseaux 1 de distribution peuvent être décomposés en différents niveaux, avec un premier réseau 2 de transport et de répartition très haute ét haute tensions THT/HT (de 35 à plus de 200 kV), utilisé pour transporter ou répartir l'énergie électrique depuis les centrales de production sur de grandes distances. Un transformateur 3 triphasé dessert un réseau de distribution 4 moyenne tension MT, usuellement entre 1 et 35 kV, plus précisément 11 kV tension simple en France, pour des transports à plus petite échelle, vers des clients de type industriels ou des postes transformant la moyenne tension en basse tension BT (en particulier 0,4 kV en France).

La ligne principale alimente donc des lignes de départ 5, 5', composées de lignes aériennes et/ou de câbles souterrains, dont certaines 5 peuvent comporter en tête un disjoncteur ou autre dispositif de coupure 6 les protégeant. Quelle que soit la solution, le réseau 4 est sujet à des défauts variés, qu'il est important de détecter et localiser afin de pallier les problèmes générés : rupture d'alimentation, dégradation de la tenue des matériels d'isolation, sans compter la sécurité des personnes. Parmi ces défauts, les plus fréquents sont les défauts monophasés 7, localisés hors du poste source, dans lesquels une phase est en contact avec la terre, ou la rupture d'un câble aérien en cas d'intempérie notamment.

Ces défauts 7, tout comme les défauts polyphasés qui concernent plusieurs phases, sont de type court-circuit et à l'origine de courants élevés, pouvant atteindre plusieurs milliers ou dizaines de milliers d'ampères, alors que les conducteurs et/ou équipements sont généralement conçus pour supporter quelques centaines d'ampères en fonctionnement nominal.

Les lignes de départ 5', ou des tronçons de ligne 5, peuvent alors comprendre un dispositif 8 de détection de défaut à la terre. Le dispositif 8 peut servir d'indicateur de passage de défaut, allumant par exemple un voyant lumineux ; un dispositif $8_1$ peut par ailleurs être associé ou intégré à un relai de protection 9 apte à commander l'ouverture des contacts du disjoncteur 6.

Une option pour détecter ce type de défaut 7 est de mesurer le courant circulant, ou des paramètres qui lui sont relatifs. Ces mesures sont cependant complétées par des mesures sur les tensions triphasées, si on veut donner la direction relative (amont ou aval) par rapport à l'équipement de détection des défauts. Or, la tension MT du réseau 4 génère une complication dans l'accès aux points de mesure, et des problématiques d'isolement du matériel électronique : ce type de détection directionnelle est difficile à mettre en oeuvre.

Dans le document FR 2 936 319, la détection directionnelle d'un défaut à la terre dans un réseau multiphasé est basée sur la dispersion des facteurs de corrélation linéaire non signés entre les courants de phase et le courant homopolaire. L'utilisation des moyenne et écart-type de ce coefficient de corrélation permet de déterminer si le défaut est en amont ou en aval de la mesure des capteurs de courants de phase des détecteurs $8_i$, $8_{i+l}$ sans utiliser de mesure de tension.

Cette solution est cependant inadaptée en cas de courant de charge élevé, notamment lorsque le ratio courant de défaut sur courant de charge est inférieur à 10 %. En particulier, lorsque le défaut est très résistant (par nature du défaut, ou lorsque le sol est résistif par exemple) ou lorsque les courants capacitifs sont faibles, typiquement pour les réseaux à forte proportion d'aérien par rapport au souterrain, la direction donnée peut être erronée. De même, la mise à la terre du secondaire du transformateur 3 peut elle-même être de nature à limiter l'amplitude d'un défaut terre, et la technique précédente est insuffisante. Sur les réseaux de distribution MT, on parle alors de défaut terre résistant (ou terre sensible) lorsque le niveau du courant de défaut est faible (et donc difficilement détectable), soit parce que la résistance de défaut est élevée, soit parce que la mise à la terre du neutre au niveau du transformateur du poste source vient limiter ce courant de défaut (cas d'une bobine de compensation, ou d'un neutre isolé par exemple), soit parce que le sol est lui-même de nature résistive.

Des mesures plus fines du courant (« *sensitive earth fault* ») doivent être réalisées pour ces défauts très résistants, et une détection via la tension est donc mise en oeuvre. Par exemple, le document EP 1 603 211 concerne un équipement communicant installé aux extrémités des lignes : la détection de rupture de conducteur est réalisée par simple détection de perte de tension de ligne. Des études plus théoriques indiquent la possibilité d'utiliser la tension inverse et/ou la tension homopolaire sur le réseau MT 4 ; cependant, les problèmes inhérents à la mesure de la tension sur des conducteurs de phase moyenne tension précédemment mentionnée restent entiers.

La détection et la localisation de ce type de défauts résistifs sur un réseau moyenne tension, notamment dans le cas de ruptures de conducteurs, est peu développée en raison de l'utilisation de mesures complexes à mettre en oeuvre.

Une alternative est proposée dans le document EP 2 533 060 (cité au titre de l'article 54(3) CBE), avec la détection et la localisation d'un défaut terre résistant et/ou d'une rupture de conducteur sur un réseau moyenne tension par l'intermédiaire d'informations relatives aux tensions dans le réseau basse tension. Ceci impose cependant l'accès au réseau BT, ce qui peut être problématique quand il s'agit d'une sous-station MT/MT intermédiaire ou de dérivation, sans transformateur MTBT.

## EXPOSE DE L'INVENTION

Parmi autres avantages, l'invention vise à pallier des inconvénients des dispositifs et procédés de détection directionnelle de défaut résistant à la terre existants. En particulier, le principe de directionnalité mis en oeuvre repose sur l'analyse de coefficients de corrélation entre les variations du signal représentatif du courant homopolaire et celles des signaux représentatifs des courants de phase, sans utilisation des différentes tensions du réseau, tout en permettant de gérer la détection et la localisation de défauts terre sensible.

Sous un de ses aspects, l'invention est relative à un procédé de détection directionnelle de défaut à la terre dans un réseau multiphasé, de préférence triphasé, dans lequel des signaux représentatifs du courant homopolaire et de chacune des phases circulant dans le tronçon de ligne surveillé est mis en mémoire sur une période de stockage prédéterminée, au moins égale à une période du réseau. De préférence, le stockage est réalisé de manière glissante, c'est-à-dire que sur la période de stockage fixée, les dernières valeurs mesurées remplacent les premières valeurs correspondantes au fur et à mesure, de sorte que les valeurs en mémoire sont représentatives du courant de charge au plus près de l'instant de mesure. Avantageusement, les signaux représentatifs des courants de phase sont filtrés, notamment analogiquement, et/ou échantillonnés, de préférence à une fréquence pennettant d'obtenir au moins une trentaine de points sur la durée prédéterminée, par exemple de l'ordre de 1,5 kHz au moins pour un réseau à 50 Hz et une période.

Le procédé de détection directionnelle comprend un premier stade de détection du défaut par comparaison d'un signal représentatif du courant homopolaire circulant dans le tronçon de ligne surveillé à un seuil de détection. Le signal représentatif du courant homopolaire peut être obtenu directement, ou par calcul à partir des signaux représentatifs des courants de chaque conducteur de phase dudit tronçon.

Si le premier stade détecte la présence d'un défaut à la terre dans ledit tronçon, le stockage des valeurs s'arrête, de sorte que les valeurs mémorisées sont représentatives du courant de charge au moment du défaut, sans avoir été altérées par ce dernier. De plus, le deuxième stade du procédé selon un mode de réalisation préféré de l'invention est déclenché. Le deuxième stade est basé sur le traitement des signaux représentatifs des courants de chaque phase dudit tronçon et du courant de défaut du même tronçon, ces signaux étant obtenus sur une durée prédéterminée suffisante, par exemple un nombre entier de périodes du réseau, inférieur ou égal à la durée de stockage des valeurs mémorisées ; les signaux représentatifs des courants de phase et homopolaire sont obtenus de la même façon que pour la mémorisation, avec mêmes filtrage et échantillonnage.

Après l'acquisition des signaux représentatifs de différents courants, le deuxième stade du procédé se poursuit par un traitement desdits signaux pour permettre d'interpréter si le défaut détecté dans le premier stade se situe en amont ou en aval du point de mesure des courants de phase. Le traitement des signaux comprend, selon l'invention, le calcul de la variation des signaux représentatifs du courant homopolaire de chacun des courants de phase, le calcul des coefficients de corrélation linéaire normalisés entre le signal représentatif de la variation du courant homopolaire du tronçon et chacune des variations des signaux représentatifs des courants de phase ; de préférence, la formule de Bravais-Pearson et/ou des coefficients signés sont utilisés. La dispersion desdits coefficients est ensuite analysée, notamment par le calcul de leur moyenne et de leur écart-type.

De préférence, la dispersion des coefficients est réalisée par formulation d'une relation comparative. En particulier, si la différence entre l'écart-type et la valeur absolue de la moyenne multipliée par deux tiers de la racine carrée de deux est positive, alors le défaut est en aval de la détection ; tout autre comparaison basée sur l'inégalité

$$3 \cdot \sigma > 2 \cdot \sqrt{2} \cdot \left| \mu \right|$$ peut être utilisée. Selon une autre option, la comparaison est réalisée graphiquement par rapport à deux demi-droites d'équation $y = \left| \dfrac{2}{3} \cdot \sqrt{2} \cdot x \right|$ : suivant que le point de coordonnées moyenne et écart-type est positionné ou non dans le demi-plan contenant l'axe des abscisses, le défaut est en amont ou en aval.

Selon un mode de réalisation préféré du procédé selon l'invention, ledit procédé de détection directionnelle est associé à un actionnement d'un dispositif de coupure pour isoler le tronçon à partir du point en aval duquel un défaut a été détecté.

Sous un autre aspect, l'invention se rapporte à un dispositif de détection directionnelle d'un défaut résistant à la terre d'une ligne dans un réseau multiphasé, de préférence triphasé, adapté pour le procédé précédent. Le dispositif de détection directionnelle selon l'invention peut être associé à des capteurs de courant de chacune des phases de la ligne, par exemple des tores de détection, qui lui fournissent les signaux représentatifs desdits courants. Le dispositif de détection directionnelle peut en outre faire partie d'un indicateur de passage de défaut, par exemple par activation de moyens d'alerte de type voyant si un défaut aval aux capteurs est détecté. Dans un mode de réalisation particulièrement préféré, le dispositif de détection directionnelle selon l'invention est associé à un relai de protection de la ligne, les moyens d'alerte provoquant l'actionnement d'un dispositif de coupure de la ligne permettant d'isoler le tronçon sur lequel un défaut a été détecté.

En particulier, le dispositif de détection directionnelle d'un défaut résistant à la terre selon l'invention comprend des premiers moyens pour recevoir des signaux représentatifs de courants de chaque phase de la ligne à surveiller ainsi que des deuxièmes moyens pour recevoir un signal représentatif du courant homopolaire de ladite ligne, ces deuxièmes moyens comprenant de préférence des moyens permettant de déduire des signaux représentatifs des courants de phase, notamment par sommation, ledit signal représentatif du courant homopolaire. Avantageusement, les premiers moyens de réception des signaux représentatifs des courants de phase sont associés à des moyens de filtrage desdits signaux, par exemple un filtre analogique ; de préférence, les premiers moyens comprennent des moyens d'échantillonnage pour obtenir un nombre de valeurs discrètes suffisantes, par exemple à fréquence supérieure à 1,5 kHz.

Le dispositif selon l'invention comprend en outre des moyens de stockage de valeurs des signaux représentatifs du courant homopolaire et du courant de chacune des phases pendant une durée de stockage prédéterminée, supérieure à une période du réseau et de préférence correspondant à un nombre entier de périodes. Les moyens de stockage sont avantageusement adaptés pour une mémorisation glissante, c'est-à-dire pour stocker les valeurs sur la dernière durée considérée, en remplaçant les premières valeurs stockées par les dernières au fur et à mesure de leur acquisition.

Le dispositif selon l'invention comprend des moyens de traitement des signaux représentatifs obtenus associés à des moyens d'activation desdits moyens de traitement, les moyens d'activation étant déclenchés par la détection de l'occurrence d'un défaut à la terre. De préférence, la détection de l'occurrence d'un défaut à la terre actionnant les moyens d'activation est réalisée par le dispositif selon l'invention qui comprend des moyens adaptés, notamment des moyens de comparaison du signal représentatif du courant homopolaire à un seuil de détection. La détection de l'occurrence d'un défaut à la terre entraîne également l'arrêt de la mémorisation des données, les moyens de stockage comprenant des moyens de désactivation correspondants, de façon à ce que les valeurs mémorisées concernent l'état du réseau avant occurrence du défaut.

Les moyens de traitement des signaux du dispositif selon l'invention comprennent des moyens pour calculer les coefficients de corrélation linéaire normalisés signés, de préférence selon la formule de Bravais-Pearson, entre le signal représentatif de la variation du courant homopolaire et chacun des signaux représentatifs des variations des courants de phase. Les moyens de calcul sont associés à des moyens de temporisation permettant l'acquisition des signaux pendant une durée correspondant à un nombre entier de périodes du réseau et inférieure, de préférence égale, à la durée de stockage. Les données calculées sont transmises à un module de calcul de la moyenne arithmétique et de l'écart-type, couplé en sortie à des moyens d'interprétation comparant les résultats pour déterminer si le défaut est en amont ou en aval du point d'obtention des signaux représentatif des courants de phase ; les moyens d'interprétation peuvent être du type graphique ou calculatoire.

## BREVE DESCRIPTION DES FIGURES

D'autres avantages et caractéristiques ressortiront plus clairement de la description qui suit de modes particuliers de réalisation de l'invention, donnés à titre illustratif et nullement limitatifs, représentés dans les figures annexées.

La figure 1, déjà décrite, représente un réseau électrique dans lequel des dispositifs de détection de défaut terre peuvent être utilisés.

La figure 2 montre de façon schématique et filtrée des signaux représentatifs des courants de phase et homopolaire, ainsi que leur variation, lors de l'apparition d'un défaut à la terre sur une phase, respectivement à l'amont et à l'aval du dispositif de détection.

La figure 3 illustre le procédé de détection selon un mode de réalisation préféré de l'invention.

La figure 4 représente un schéma bloc d'un dispositif de détection de défaut terre selon un mode de réalisation préféré de l'invention.

## DESCRIPTION DETAILLEE D'UN MODE DE REALISATION PREFERE

Le dispositif 10 de détection directionnelle de défaut 7 selon l'invention peut être utilisé dans tout réseau multiphasé 1, tel que celui décrit en figure 1, en lieu et place des dispositifs 8 existants. Dans le mode de réalisation et d'utilisation préféré illustré de l'invention, la ligne 5 sur laquelle le dispositif 10 est mis en place comprend trois conducteurs de phase $5_A$, $5_B$, $5_C$ et le réseau est équilibré, c'est-à-dire que le courant homopolaire $I_0$ est nul en l'absence de défaut. Cependant, il est possible de s'écarter de cette situation idéale, et le réseau peut comprendre un autre nombre de phases.

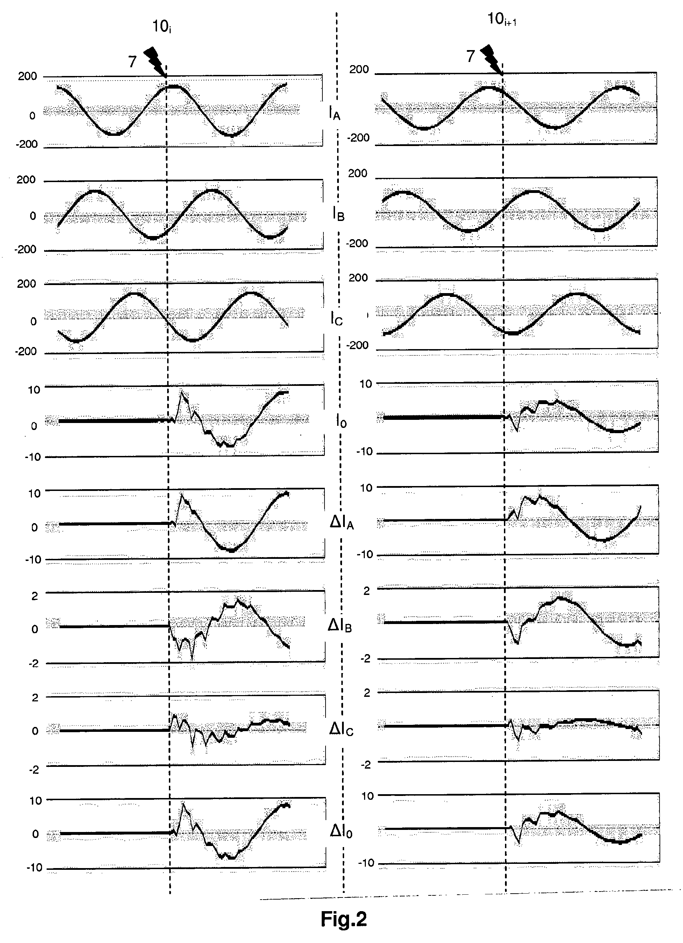

Lors de l'apparition d'un défaut à la terre 7 sur une des phases A, le courant de ladite phase $I_A$ devient idéalement nul en aval du défaut 7 et voit son amplitude augmenter en amont ; cependant, si le défaut à la terre 7 est très résistant, les variations du courant induites par le défaut 7 sont très faibles, jusqu'à 20 à 40 fois moindre que le courant de charge, et peuvent être masquées par les courants capacitifs. Tel qu'illustré en figure 2, un capteur de courant 12A sur le conducteur en défaut 5A fournit alors un signal représentatif du courant $I_A$ qui ne marque pas une rupture nette au niveau du défaut 7, car le courant de défaut est faible et est difficilement perceptible.

Cependant, l'invention montre qu'il est possible de s'affranchir de ce problème d'échelle en soustrayant le courant de charge mesuré avant défaut du courant de défaut $I_A$ : tel qu'illustré en figure 2, une rupture nette dans le signal fourni par le capteur 12A devient visible. Qui plus est, la variation de courant $\Delta I_A$ dans la phase en défaut diffère selon que le dispositif selon l'invention est disposé en amont $10_{i+1}$ ou en aval $10_i$ dudit capteur 12.

La figure 2 montre également :

- le courant I et sa variation du courant $\Delta I$, qui sont ponctuellement altérés dans les deux autres phases B et C, mais dans des proportions moins importantes que dans la phase A ;
- le courant homopolaire $I_0$ détecté sur la ligne 5, soit par un capteur approprié 12, soit par calcul depuis les trois courants de phase $I_A$, $I_B$, $I_C$ obtenus par les capteurs 12A, 12B, 12C, et sa variation.

Selon l'invention, les coefficients de corrélation entre les différentes courbes sont utilisés pour déterminer si le défaut 7 est localisé en amont ou en aval des capteurs 12 fournissant des signaux représentatifs des courants de la ligne 5. De fait, on y constate que, après occurrence du défaut résistant à la terre, dans le cas d'un défaut 7 ayant lieu en aval du dispositif $10_i$, la ressemblance entre la variation du courant homopolaire $I_0$ et celle du courant $I_A$ de la phase en défaut est importante, au contraire de la ressemblance, faible, entre la variation du courant homopolaire $I_0$ et celle des courants $I_B$, $I_C$ des autres phases ; ainsi, les coefficients de corrélation normalisés avec celle du courant homopolaire $I_0$ devraient être, en valeur absolue, proches de l'unité pour la phase A et faibles, par exemple proches de $\pm$ 0,1, pour les autres phases. Inversement, dans le cas d'un défaut 7 ayant lieu en amont du dispositif $10_{i+1}$, après son occurrence, la ressemblance de la variation du courant homopolaire $I_0$ avec celle du courant $I_A$ de la phase en défaut est faible alors que la ressemblance entre la variation du courant homopolaire $I_0$ et celle des courants $I_B$, $I_C$ des autres phases reste moyenne ; ainsi, les coefficients de corrélation normalisés signés avec la variation du courant homopolaire $I_0$ devraient rester moyens, par exemple proches de $\pm$ 0,5, pour les phases B et C, et être proche de zéro pour la phase A.

Le coefficient de corrélation linéaire normalisé utilisé dans le procédé selon l'invention est de préférence obtenu par la formule de Bravais-Pearson et signé : de fait, les capteurs 12 fournissent un signal de courant alternatif circulant dans chacune des phases $5_A$, $5_B$, $5_C$ qu'il est préféré d'échantillonner de façon à obtenir un nombre défini de valeurs discrètes représentatives du courant. Avantageusement, le nombre N de valeurs fourni par l'échantillonnage est adapté à la durée d'acquisition $T_{acq}$ pour optimiser la reproductibilité et la fiabilité des résultats de la formule de Bravais-Pearson, c'est-à-dire de préférence plus de 30 valeurs dans le cas d'une durée d'acquisition $T_{acq}$ égale à une période du réseau, avec par exemple une fréquence d'échantillonnage de l'ordre de 1,5 kHz pour un réseau 4 triphasé à 50 Hz.

De la même façon, le calcul des variations respectives des courants de phases et du courant homopolaire $\Delta I$ est réalisé point par point, avec, pour chaque valeur mesurée, la soustraction de la valeur du courant de charge avant défaut au même instant sur la sinusoïde du signal. Il est préféré de ne pas utiliser de fenêtre de mémoire fixe pour les courants de référence, bien que ce paramètre soit classiquement utilisé pour, par exemple, les fonctions de mesure et/ou de qualimétrie demandant la soustraction de valeurs de référence. De fait, la plupart des réseaux 4 présentent des fluctuations en termes de charge et de fréquence : la fréquence de 50 Hz (ou 60 Hz) reste la valeur moyenne par rapport à la fréquence réelle qui n'est pas figée. Ainsi, un échantillonnage sur N points peut entraîner des mesures décalées de quelques microsecondes sur la sinusoïde par rapport aux instants de référence pris dans une fenêtre fixe, surtout si elle est éloignée du point de mesure, ce qui génèrerait des écarts sur le calcul de la variation de courant $\Delta I$.

Selon l'invention, les valeurs de référence représentatives du courant de charge juste avant défaut sont donc stockées selon le principe de mémoire glissante, sur une fenêtre d'une durée au moins équivalente à $T_{acq}$ : tant qu'il n'y a pas de défaut détecté, les valeurs représentatives du signal mesurées par les capteurs 12 remplacent les premières valeurs mémorisées pour le même instant sur la sinusoïde, afin de conserver les échantillons immédiatement antérieurs au défaut, ce qui minimise les possibles décalages occasionnés par une fluctuation de la fréquence et/ou de la charge.

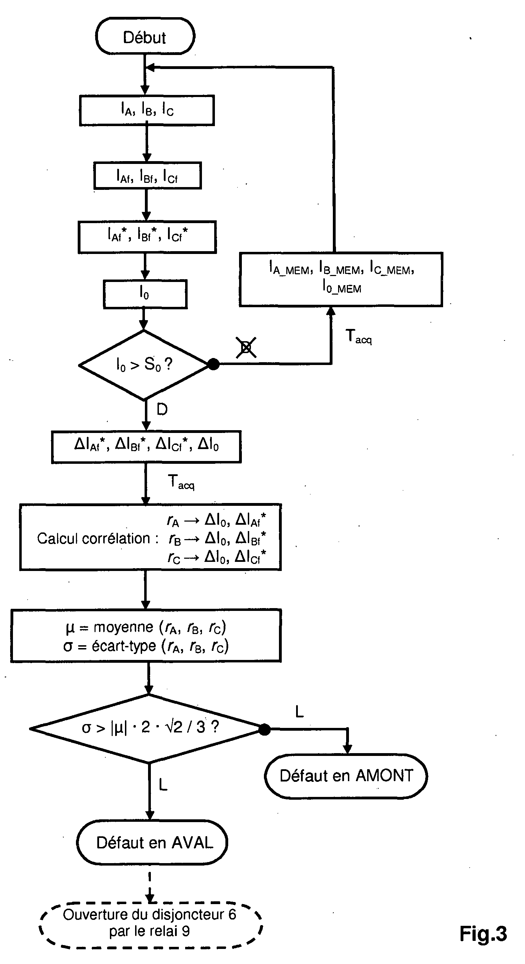

Ainsi, dans le procédé selon l'invention schématisé en figure 3, les signaux représentatifs des courants de phase, de préférence filtrés, sont acquis sur une durée d'acquisition $T_{acq}$, puis échantillonnés ; parallèlement, le courant homopolaire $I_0$ est calculé pour la même durée, ou il peut être mesuré directement par l'intermédiaire d'un tore dédié 12. Les valeurs sont stockées sur une durée d'acquisition $T_{acq}$ dans une mémoire appropriée, ledit stockage étant glissant, c'est-à-dire que, tant qu'aucun défaut n'est détecté, la dernière valeur mesurée/acquise remplace la précédente.

Une fois le défaut 7 détecté D, par exemple en comparant le courant homopolaire $I_0$ (ou sa variation) à un seuil $S_0$, les valeurs stockées dans la mémoire $I_{0\_MEM}$, $I_{A\_MEM}$, $I_{B\_MEM}$, $I_{C\_MEM}$ sont conservées sans plus être remplacées, et les signaux représentatifs des courants de phase, de préférence filtrés comme avant défaut, sont acquis sur une durée d'acquisition $T_{acq}$, puis échantillonnés ; parallèlement, le courant homopolaire $I_0$ est calculé pour la même durée. Ces échantillons $I_{Af}^*$, $I_{Bf}^*$, $I_{Cf}^*$, $I_0$ font ensuite l'objet d'une soustraction terme à terme des valeurs $I_{A\_MEM}$, $I_{B\_MEM}$, $I_{C\_MEM}$, $I_{0\_MEM}$ stockées dans la mémoire glissante, afin de déterminer les variations des signaux filtrés échantillonnés des courants de phase et du courant homopolaire. Les coefficients de corrélation signés entre les variations des signaux $\Delta I_{Af}^*$, $\Delta I_{Bf}^*$, $\Delta I_{Cf}^*$, et $\Delta I_0$ sont calculés par la formule de Bravais-Pearson selon l'équation (1), dans laquelle $r_{XY}$ désigne l'indice de corrélation linéaire signé entre les deux variables X, Y dont respectivement N valeurs ponctuelles x, y sont connues.

$$(1) \qquad r_{XY} = \frac{\sum_{k=1}^{N}\left(x_k - \frac{\sum_{i=1}^{N} x_i}{N}\right) \times \left(y_k - \frac{\sum_{i=1}^{N} y_i}{N}\right)}{\sqrt{\sum_{k=1}^{N}\left(x_k - \frac{\sum_{i=1}^{N} x_j}{N}\right)^2} \times \sqrt{\sum_{k=1}^{N}\left(y_k - \frac{\sum_{i=1}^{N} y_j}{N}\right)^2}}$$

On obtient ainsi trois coefficients de corrélation linéaire normalisés signés $r_A$, $r_B$, $r_C$. Tel qu'indiqué plus haut, suivant que le défaut 7 est en amont ou en aval, les coefficients $r_A$ sont plus proches de 1 ou de 0. Suivant l'invention, pour évaluer cette proximité, la moyenne arithmétique $\mu$ et l'écart-type $\sigma$ de la distribution des coefficients de corrélation sont utilisés. De fait, un couple moyenne/écart-type $(\mu, \sigma)$ à moyenne élevée et écart type faible (par exemple $\mu > 0,7$ et $\sigma < 0,5$) correspond à un défaut amont, contrairement à un couple moyenne/écart-type $(\mu, \sigma)$ à moyenne faible et écart type élevé (par exemple $\mu < 0,5$ et $\sigma > 0,5$) qui correspond à un défaut aval. A noter que le coefficient de corrélation est ici signé, contrairement à celui utilisé dans le document FR 2 936 319 : les variations dues au courant de défaut sont faibles et l'information fournie par le signe ne peut être ignorée.

Plus particulièrement, on constate que, pour un défaut 7 en aval de la détection $10_i$, est vérifiée la relation suivante (2), alors que pour un défaut amont 7, $10_{i+1}$, l'inverse est vrai, c'est-à-dire : $3 \cdot \sigma < 2 \cdot \sqrt{2} \cdot |\mu|$.

$$(2) \qquad \sigma > \left|\frac{2 \cdot \sqrt{2} \cdot \mu}{3}\right|$$

Dans un procédé préféré selon l'invention, une fois la moyenne et l'écart-type calculés, la comparaison selon la relation (2), ou toute relation qui en dérive directement, est effectuée et, selon le résultat, l'interprétation directionnelle L quant à la position du défaut est donnée, soit signalée à l'extérieur, soit transmise à un relais 9 pour couper un disjoncteur 6 en amont, ou tout autre utilisation.

Pour alléger cette étape de calcul du procédé selon l'invention, il est possible graphiquement de déterminer la localisation relative aval ou amont du défaut 7 en positionnant le point de coordonnées $(\mu, \sigma)$ sur un graphe (x,y) où sont tracées deux demi-droites d'équation (3) : si le point est situé dans le demi-plan contenant l'axe des abscisses (x,0), il s'agit d'un défaut amont.

$$(3) \quad y = \left| \frac{2}{3} \cdot \sqrt{2} \cdot x \right|$$

Le procédé selon l'invention peut être mis en place dans un relai de protection 9, dans un indicateur de défaut avec système d'alerte, par implémentation dans un dispositif de détection directionnelle de défaut à la terre 10 adapté.

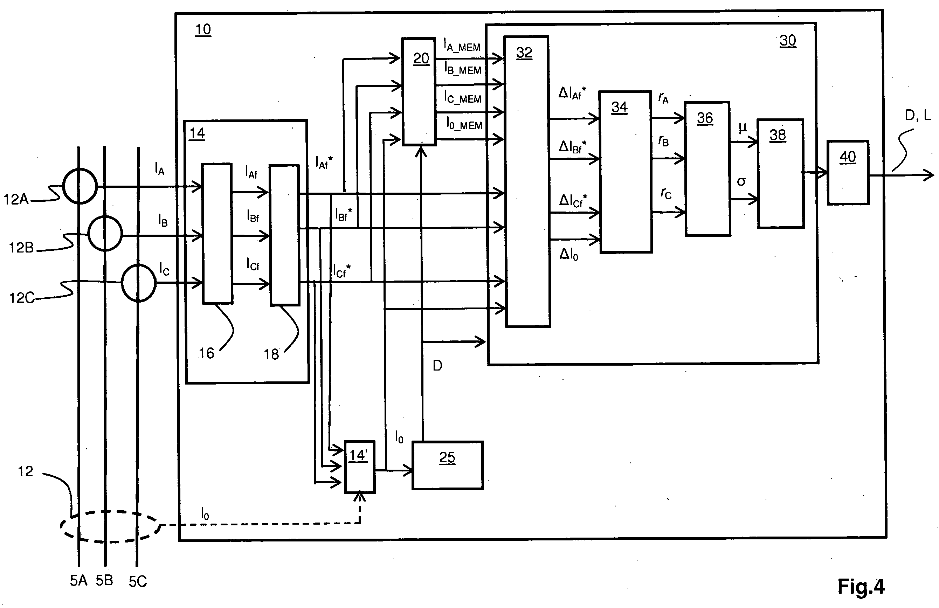

Un dispositif 10 selon un mode de réalisation préféré de l'invention est schématisé en figure 4. Il comprend des moyens 14 permettant d'obtenir des signaux représentatifs des courants de phase fournis par des capteurs 12A, 12B, 12C adaptés, par exemple des tores de détection, avantageusement avec un filtrage par moyens 16 adaptés comme un filtre analogique. Dans le mode de réalisation préféré, les signaux, filtrés $I_{Af}$, $I_{Bf}$, $I_{Cf}$, sont en outre conditionnés par échantillonnage et les moyens d'obtention des signaux représentatifs 14 comprennent un module d'échantillonnage 18, fonctionnant avantageusement à plus de 1,5 kHz, fournissant ainsi des signaux échantillonnés filtrés à traiter $I_{Af}^*$, $I_{Bf}^*$, $I_{Cf}^*$.

Le dispositif 10 selon l'invention comprend en outre des moyens 14' permettant d'obtenir un signal représentatif du courant homopolaire $I_0$. Ces moyens peuvent être couplés directement à un tore 12 de détection du courant concerné entourant la ligne 5 (pointillés) ; alternativement, les moyens 14' relatifs à la valeur du courant homopolaire $I_0$ déterminent ledit courant par traitement des signaux relatifs aux courants de phase $I_A$, $I_B$, $I_C$ (non illustré), avantageusement filtrés $I_{Af}$, $I_{Bf}$, $I_{Cf}$ (non illustré), éventuellement échantillonnés $I_{Af}^*$, $I_{Bf}^*$, $I_{Cf}^*$ (traits pleins).

Le dispositif 10 selon l'invention comprend en outre des moyens de stockage 20 adaptés pour garder en mémoire de manière glissante sur une fenêtre de durée prédéterminée les valeurs précédentes des signaux échantillonnés filtrés d'un courant de phase $I_{Af}^*$, $I_{Bf}^*$, $I_{Cf}^*$ et du signal représentatif d'un courant homopolaire $I_0$ ; les signaux ainsi stockés sont mémorisés sous forme de valeurs de référence $I_{A\_MEM}$, $I_{B\_MEM}$, $I_{C\_MEM}$, $I_{0\_MEM}$.

Outre leur entrée dans les moyens de détermination 14' du signal représentatif du courant homopolaire $I_0$ et les moyens de stockage 20, les signaux représentatifs des courants de phases échantillonnés filtrés $I_{Af}^*$, $I_{Bf}^*$, $I_{Cf}^*$ sont transmis à un module de traitement 30 qui comprend une quatrième entrée pour le signal représentatif du courant homopolaire $I_0$, quatre autres entrées pour les valeurs mémorisées dans les moyens de stockage 20, et qui est activé en fonction de la détection D d'un défaut à la terre 10. A cette fin, le module de traitement 30 est connecté à un dispositif de détection de défaut 25 quelconque, de préférence ici un module de comparaison du courant homopolaire $I_0$ avec un seuil de détection $S_d$ : si le seuil est dépassé, alors un défaut D est détecté et le module de traitement 30 est activé.

Le module de traitement 30 comporte successivement un dispositif de calcul 32 des variations respectives des signaux d'entrée $I_{Af}^*$, $I_{Bf}^*$, $I_{Cf}^*$, $I_0$, par rapport aux signaux d'entrée mémorisés $I_{A\_MEM}$, $I_{B\_MEM}$, $I_{C\_MEM}$, $I_{0\_MEM}$, un dispositif de calcul 34 de coefficients de corrélation normalisés r à partir des quatre signaux d'entrée $\Delta I_{Af}^*$, $\Delta I_{Bf}^*$, $\Delta I_{Cf}^*$, $\Delta I_0$, un dispositif de calcul 36 de la moyenne arithmétique $\mu$ et de l'écart-type $\sigma$ des trois données entrées $r_A$, $r_B$, $r_C$, un dispositif de comparaison 38 avec deux entrées $(\mu, \sigma)$ et qui est relié à des moyens d'interprétation 40 dont la sortie est un signal L de détection directionnelle de défaut terre en aval ou en amont des capteurs 12 selon le résultat de l'interprétation.

Les moyens de calcul 32 des variations respectives des signaux d'entrée $I_{Af}^*$, $I_{Bf}^*$, $I_{Cf}^*$. $I_0$, par rapport aux signaux d'entrée mémorisés $I_{A\_MEM}$, $I_{B\_MEM}$, $I_{C\_MEM}$, $I_{0\_MEM}$, réalisent ces différences terme à terme pour chaque échantillon de la fenêtre de durée d'acquisition $T_{acq}$. Ces moyens fournissent en sortie les variations des signaux filtrés échantillonnés des courants de phase $\Delta I_{Af}^*$, $\Delta I_{Bf}^*$, $\Delta I_{Cf}^*$ et la variation du signal représentatif du courant homopolaire $\Delta I_0$.

Les moyens de calcul de coefficients de corrélation normalisés signés 34 utilisent de préférence la formule (1) de Bravais-Pearson et sont associés à des moyens de temporisation afin de s'assurer que les variations des signaux filtrés échantillonnés des courants de phase $\Delta I_{Af}^*$, $\Delta I_{Bf}^*$, $\Delta I_{Cf}^*$ et la variation du signal représentatif du courant homopolaire $\Delta I_0$ ont été acquises sur une durée suffisante $T_{acq}$, par exemple une période du réseau 1, voire plus.

Les moyens de comparaison 38 fournissant la valeur au module d'interprétation 40 peuvent utiliser différentes fonctions. En particulier, les moyens de comparaison 38 peuvent comprendre une comparaison graphique par des deux valeurs entrées par rapport à un demi-plan délimité par les demi-droites d'équation (3) ; les moyens 38 peuvent déterminer la différence entre neuf huitièmes du carré de l'écart-type et le carré de la moyenne, pour la comparer à zéro ; toute autre option est possible.

Le dispositif 10 de la figure 4 peut être avantageusement associé à un relai de protection 9 pour des réseaux électriques, ou à un indicateur de passage de défaut pour des lignes 5 moyenne tension souterraines connectées en réseau 1, la sortie du module d'interprétation déclenchant la coupure d'un disjoncteur 6, l'allumage d'un voyant ou tout autre moyen de sécurité et/ou d'alerte.

Ainsi, selon l'invention, un procédé et un dispositif de détection directionnelle 10 d'un défaut à la terre 7 d'une ligne 5 d'un réseau multiphasé 1 ont été réalisés sans mesure de tension, ce qui allège autant les dispositifs que leur mise en oeuvre, permettant de détecter et localiser des défauts terre sensibles sur un réseau chargé. De fait, bien que le mode de réalisation soit particulièrement adapté pour la détection directionnelle d'un défaut terre sensible, notamment lorsque l'amplitude du courant de défaut est inférieure à 10 % du courant de charge, elle s'applique bien entendu dans les autres cas en lieu et place du procédé décrit dans FR 2 936 319, quoique plus lourde à mettre en oeuvre.

Bien que l'invention ait été décrite en référence à un réseau de distribution triphasé dans lequel le neutre est mis à la terre par impédance compensée, elle ne s'y limite pas : d'autres types de réseaux multiphasés peuvent être concernés par l'invention ; en particulier, tout régime de neutre est approprié. Par ailleurs, bien que décrit avec détermination et traitement du courant homopolaire instantané $I_0$ pour la détection du défaut, le procédé selon l'invention peut utiliser la variation dudit courant $I_0$ par rapport à sa valeur déterminée sur une période préalable : cette variante s'avère particulièrement intéressante dans le cas de réseaux présentant un léger déséquilibre entre phases, dont le courant homopolaire $I_0$ est donc non nul en situation hors défaut.

De fait, les différents circuits, modules et fonctions présentés dans le cadre du mode de réalisation préféré de l'invention peuvent être réalisés en composants analogiques, numériques ou sous une forme programmable opérant avec des microcontrôleurs ou des microprocesseurs, et les signaux représentatifs décrits peuvent avoir des formes de signaux électriques ou électroniques, de valeurs de données ou d'information dans des mémoires ou des registres, de signaux optiques visualisables notamment sur des voyants ou des écrans, ou de signaux mécaniques agissant avec des actionneurs. De même, les capteurs de courant peuvent être différents des transformateurs décrits, comme des capteurs à effet Hall ou des magnétorésistances.

## Revendications

1. Dispositif (10) de détection directionnelle d'un défaut à la terre (7) dans un réseau multiphasé comportant :

   - des premiers moyens (14) pour recevoir des signaux représentatifs du courant ($I_A$, $I_B$, $I_C$) de chacune des phases ;
   - des deuxièmes moyens (14') pour recevoir un signal représentatif du courant homopolaire ($I_0$) de l'ensemble des phases ;
   - des moyens (30) de traitement des signaux représentatifs de courant, comportant des moyens (34) de calcul de coefficient de corrélation normalisés ($r_A$, $r_B$, $r_C$) et des moyens (36) de calcul de la moyenne ($\mu$) et de l'écart-type ($\sigma$) entre les coefficients de corrélation calculés ;
   - des moyens d'activation desdits moyens de traitement (30) en fonction d'un signal (D) de détection de l'occurrence d'un défaut à la terre dans le réseau (1) ;
   - des moyens d'interprétation des résultats du traitement des signaux comprenant des moyens de comparaison de ladite moyenne ($\mu$) et dudit écart-type ($\sigma$) pour déterminer si le défaut est en amont ou en aval du dispositif (10) ;

   **caractérisé en ce que** le dispositif (10) comprend en outre des moyens de stockage (20) de valeurs des signaux représentatifs du courant homopolaire et de chacune des phases ($I_{0\_MEM}$, $I_{A\_MEM}$, $I_{B\_MEM}$, $I_{C\_MEM}$) pendant une durée de stockage ($T_{acq}$) antérieure au signal (D) de détection de l'occurrence d'un défaut à la terre (7), et les moyens de traitement des signaux (30) comprennent des moyens de détermination de la variation du signal représentatif du courant homopolaire et de chacune des phases ($\Delta I_0$, $\Delta I_A$, $\Delta I_B$, $\Delta I_C$) par rapport aux valeurs stockées ($I_{0\_MEM}$, $I_{A\_MEM}$, $I_{B\_MEM}$, $I_{C\_MEM}$) sur une durée prédéterminée inférieure ou égale à la durée de stockage, les moyens de calcul de coefficient de corrélation normalisés (34) étant adaptés pour calculer le coefficient de corrélation ($r_A$, $r_B$, $r_C$) entre la variation du signal représentatif du courant homopolaire ($\Delta I_0$) et la variation de chacun des signaux représentatif du courant de phase ($\Delta I_A$, $\Delta I_B$, $\Delta I_C$).

2. Dispositif de détection directionnelle (10) selon la revendication 1 dans lequel la durée de stockage correspond à un nombre entier de périodes du réseau (1) et la durée déterminée est égale à la durée de stockage ($T_{acq}$).

3. Dispositif de détection selon l'une des revendications 1 ou 2 dans lequel les moyens de stockage (20) sont adaptés pour stocker les valeurs sur une période glissante et comprennent des moyens de désactivation en fonction d'un signal (D) de détection de l'occurrence d'un défaut à la terre dans le réseau (1).

4. Dispositif de détection directionnelle (10) selon l'une des revendications 1 à 3 comprenant en outre des moyens (18) de détection de l'occurrence d'un défaut à la terre dans le réseau reliés aux moyens d'activation des moyens de traitement des signaux (30) et aux moyens de stockage (20) comprenant un comparateur du signal représentatif du courant homopolaire ($I_0$) à un seuil de détection ($S_0$).

5. Dispositif de détection directionnelle (20) selon l'une des revendications 1 à 4 dans lequel les premiers moyens de réception (14) de signaux représentatifs des courants de chaque phase ($I_A$, $I_B$, $I_C$) comprennent des moyens d'échantillonnage (18) adaptés à fournir un nombre de valeurs suffisant pendant la durée prédéterminée et la durée de stockage ($T_{acq}$).

6.  Indicateur de passage de défaut à la terre comprenant des capteurs de courant ($12_A$, $12_B$, $12_C$) disposés sur chaque conducteur de phase ($5_A$, $5_B$, $5_C$) d'un réseau électrique (1) à surveiller et comprenant un dispositif de détection directionnelle de défaut (10) selon l'une des revendications 1 à 5 connecté auxdits capteurs de courant ($12_A$, $12_B$, $12_C$) pour recevoir les signaux représentatifs de courant de phase ($I_A$, $I_B$, $I_C$).

7.  Relai (9) de protection à la terre comprenant au moins un indicateur de défaut selon la revendication 6 et des moyens d'actionnement d'un dispositif de coupure (6) en fonction des résultats des moyens d'interprétation (40) du dispositif de détection directionnelle (10) de l'indicateur.

8.  Procédé de détection directionnelle (D, L) d'un défaut à la terre (7) dans un réseau multiphasé (1) dans lequel des signaux représentatifs du courant homopolaire ($I_{0\_MEM}$) et de chacun des courants de phase ($I_{A\_MEM}$, $I_{B\_MEM}$, $I_{C\_MEM}$) sont mémorisés sur une durée ($T_{acq}$) d'au moins une période du réseau, comprenant le déclenchement, suite à l'obtention d'un signal (D) indicateur de la présence dudit défaut à la terre (10), de la détermination directionnelle (L) du défaut (10), ladite détermination directionnelle comprenant les étapes successives de :

    - obtention de signaux représentatifs de chacun des courants de phase ($I_A$, $I_B$, $I_C$) sur une durée prédéterminée ($T_{acq}$) inférieure ou égale à la durée de mémorisation ;
    - obtention d'un signal représentatif du courant homopolaire ($I_0$) circulant dans le réseau sur la même durée prédéterminée ($T_{acq}$) ;
    - traitement des signaux représentatifs des courants de phase et de défaut à la terre ($I_0$, $I_A$, $I_B$, $I_C$) ;
    - interprétation des résultats du traitement des signaux pour indiquer si le défaut détecté (D) se situe en aval ou en amont de l'endroit où les signaux représentatifs des courants de phase ($I_A$, $I_B$, $I_C$) ont été obtenus ;

    **caractérisé en ce que** ladite étape de traitement des signaux comporte :

    - le calcul de la variation du courant homopolaire ($I_0$) et de chacun des courants de phase ($I_A$, $I_B$, $I_C$) sur la durée prédéterminée ($T_{acq}$) par rapport aux valeurs mémorisées ($I_{0\_MEM}$, $I_{A\_MEM}$, $I_{B\_MEM}$, $I_{C\_MEM}$) ;
    - le calcul des coefficients de corrélation normalisés ($r_A$, $r_B$, $r_C$) entre les variations des signaux de courant homopolaire ($\Delta I_0$) et de chacun des courants de phase ($\Delta I_A$, $\Delta I_B$, $\Delta I_C$) sur la durée prédéterminée ($T_{acq}$) ;
    - le calcul de la moyenne arithmétique ($\mu$) et de l'écart-type ($\sigma$) desdits coefficients de corrélation ($r_A$, $r_B$, $r_C$) ;
    - ladite interprétation étant réalisée par une comparaison utilisant ladite moyenne ($\mu$) et ledit écart-type ($\sigma$).

9.  Procédé de détection directionnelle selon la revendication 8 dans lequel la mémorisation des valeurs représentatives ($I_{0\_MEM}$, $I_{A\_MEM}$, $I_{B\_MEM}$, $I_{C\_MBM}$) est obtenue de façon glissante tant que le signal indicateur de la présence du défaut (D) n'est pas obtenu.

10. Procédé de détection directionnelle selon la revendication 8 ou 9 dans lequel le signal (D) indicateur de la présence d'un défaut à la terre (7) est obtenu par la réception d'un signal représentatif du courant homopolaire ($I_0$) circulant dans le réseau (1) et le résultat d'une comparaison du signal de courant homopolaire ($I_0$) à un seuil de détection de défaut ($S_0$).

11. Procédé de détection directionnelle selon l'une des revendications 8 à 10 dans lequel l'étape d'interprétation comprend la comparaison avec zéro de la différence entre le carré du triple de l'écart-type ($\sigma$) et huit fois le carré de la moyenne ($\mu$).

12. Procédé de détection directionnelle selon l'une des revendications 8 à 10 dans lequel l'étape d'interprétation comprend la comparaison graphique de la moyenne ($\mu$) et de l'écart-type ($\sigma$) avec deux demi-droites d'équation

$$y = \left| \frac{2\sqrt{2}}{3} \cdot x \right|.$$

13. Procédé de détection directionnelle selon l'une des revendications 8 à 12 dans lequel l'étape de fourniture des signaux représentatifs des courants de phase ($I_A$, $I_B$, $I_C$) comporte un échantillonnage du courant à fréquence supérieure à 1,5 kHz.

14. Procédé de détection directionnelle selon l'une des revendications 8 à 13 dans lequel le calcul de coefficients de corrélation normalisés ($r_A$, $r_B$, $r_C$) est réalisé selon la formule de Bravais-Pearson.

15. Procédé de protection d'une ligne de courant (5) lors de l'apparition d'un défaut à la terre (7) comprenant l'actionnement d'un dispositif de coupure (6) de ladite ligne (5) si un défaut à la terre (7) a été détecté par un procédé selon l'une des revendications 8 à 14 à l'aval dudit dispositif de coupure (6).

**Patentansprüche**

1. Vorrichtung (10) zur Richtungserkennung eines Erdschlusses (7) in einem Mehrphasennetz, die Folgendes aufweist:

    - erste Mittel (14) zum Empfangen von Signalen, die für den Strom ($I_A$, $I_B$, $I_C$) von jeder der Phasen charakteristisch sind;
    - zweite Mittel (14') zum Empfangen eines Signals, das für den Nullstrom ($I_0$) sämtlicher Phasen charakteristisch ist;
    - Mittel (30) zur Verarbeitung der Signale, die für Strom charakteristisch sind, die Mittel (34) zur Berechnung normalisierter Korrelationskoeffizienten ($r_A$, $r_B$, $r_C$) und Mittel (36) zur Berechnung des Mittels ($\mu$) und der Standardabweichung ($\sigma$) zwischen den berechneten Korrelationskoeffizienten aufweisen;
    - Mittel zur Aktivierung der Verarbeitungsmittel (30) in Abhängigkeit von einem Signal (D) der Ermittlung des Auftretens eines Erdschlusses in dem Netz (1);
    - Mittel zur Interpretation der Ergebnisse der Verarbeitung der Signale, die Mittel zum Vergleich des Mittels ($\mu$) und der Standardabweichung ($\sigma$) aufweist, um zu bestimmen, ob der Erdschluss der Vorrichtung (10) vor- oder nachgeschaltet liegt;

    **dadurch gekennzeichnet, dass** die Vorrichtung (10) ferner Mittel (20) zur Speicherung von Signalwerten, die für den Nullstrom und jede der Phasen ($I_{0\_MEM}$, $I_{A\_MEM}$, $I_{B\_MEM}$, $I_{C\_MEM}$) charakteristisch sind, während einer Speicherungsdauer ($T_{acq}$) vor dem Signal (D) der Ermittlung des Auftretens eines Erdschlusses (7) aufweist, und die Mittel zur Verarbeitung der Signale (30) Mittel zur Bestimmung der Veränderung des Signals, das für den Nullstrom und für jede der Phasen ($\Delta I_0$, $\Delta I_A$, $\Delta I_B$, $\Delta I_C$) charakteristisch ist, in Bezug zu den gespeicherten Werten ($I_{0\_MEM}$, $I_{A\_MEM}$, $I_{B\_MEM}$, $I_{C\_MEM}$) während einer vorbestimmten Dauer, die kleiner oder gleich der Speicherungsdauer ist, aufweisen, wobei die Mittel zur Berechnung der normalisierten Korrelationskoeffizienten (34) angepasst sind, um den Korrelationskoeffizienten ($r_A$, $r_B$, $r_C$) zwischen der Veränderung des Signals, das für den Nullstrom ($\Delta I_0$) charakteristisch ist, und der Veränderung von jedem der Signale zu berechnen, die für den Phasenstrom ($\Delta I_A$, $\Delta I_B$, $\Delta I_C$) charakteristisch sind.

2. Vorrichtung zur Richtungserkennung (10) nach Anspruch 1, wobei die Speicherungsdauer einer ganzen Zahl von Perioden des Netzes (1) entspricht und die bestimmte Dauer gleich der Speicherungsdauer ($T_{acq}$) ist.

3. Erkennungsvorrichtung nach einem der Ansprüche 1 oder 2, wobei die Speicherungsmittel (20) angepasst sind, um die Werte über einen gleitenden Zeitraum zu speichern und Mittel zur Deaktivierung in Abhängigkeit von einem Signal (D) der Erkennung des Auftretens eines Erdschlusses in dem Netz (1) aufweisen.

4. Richtungserkennungsvorrichtung (10) nach einem der Ansprüche 1 bis 3, die ferner Mittel (18) zur Erkennung des Auftretens eines Erdschlusses in dem Netz aufweisen, die mit den Mitteln zur Aktivierung der Mittel zur Verarbeitung der Signale (30) und mit den Speicherungsmitteln (20) verbunden sind, die einen Komparator des Signals, das für den Nullstrom ($I_0$) charakteristisch ist, mit einer Erkennungsschwelle ($S_0$) aufweisen.

5. Richtungserkennungsvorrichtung **(10)** nach einem der Ansprüche 1 bis 4, wobei die ersten Mittel (14) zum Empfang von Signalen, die für die Ströme von jeder Phase ($I_A$, $I_B$, $I_C$) charakteristisch sind, Abtastungsmittel (18) aufweisen, die angepasst sind, um eine genügende Anzahl von Werten während der vorbestimmten Dauer und der Speicherungsdauer ($T_{acq}$) zu liefern.

6. Erdschlussanzeiger, der Stromsensoren ($12_A$, $12_B$, $12_C$) aufweist, die auf jedem Phasenleiter ($5_A$, $5_B$, $5_C$) eines zu überwachenden Stromnetzes (1) angeordnet sind, und eine Vorrichtung zur Richtungserkennung eines Erdschlusses (10) nach einem der Ansprüche 1 bis 5 aufweist, die mit den Stromsensoren ($12_A$, $12_B$, $12_C$) verbunden ist, um Signale zu empfangen, die für den Phasenstrom ($I_A$, $I_B$, $I_C$) charakteristisch sind.

7. Erdschluss-Schutzrelais (9), das mindestens einen Erdschlussanzeiger nach Anspruch 6 und Mittel zur Betätigung einer Abschaltvorrichtung (6) in Abhängigkeit von den Ergebnissen der Interpretationsmittel (40) der Richtungserkennungsvorrichtung (10) des Anzeigers aufweist.

8. Verfahren zur Richtungserkennung (D, L) eines Erdschlusses (7) in einem Mehrphasennetz (1), wobei die Signale, die für den Nullstrom ($I_{0\_MEM}$) und jeden der Phasenströme ($I_{A\_MEM}$, $I_{B\_MEM}$, $I_{C\_MEM}$) charakteristisch sind, während einer Dauer ($T_{acq}$) von mindestens einer Netzperiode gespeichert werden, das die Auslösung der Richtungserkennung (L) des Erdschlusses (10) infolge des Erhalts eines Signals (D), das das Vorhandensein des Erdschlusses (10) angibt, aufweist, wobei die Richtungserkennung die folgenden aufeinanderfolgenden Schritte aufweist:

 - Erhalt von Signalen, die für jeden der Phasenströme ($I_A$, $I_B$, $I_C$) über eine vorbestimmte Dauer ($T_{acq}$) charakteristisch sind, die kleiner oder gleich der Speicherungsdauer ist;
 - Erhalt eines Signals, das für den Nullstrom ($I_0$) charakteristisch ist, der in dem Netz während der gleichen vorbestimmten Dauer ($T_{acq}$) fließt;
 - Verarbeitung von Signalen, die für die Phasen- und Erdschlussströme ($I_0$, $I_A$, $I_B$, $I_C$) charakteristisch sind;
 - Interpretation der Ergebnisse der Verarbeitung der Signale, um anzugeben, ob der erkannte Erdschluss (D) sich dem Ort, an dem die Signale erhalten wurden, die für die Phasenströme ($I_A$, $I_B$, $I_C$) charakteristisch sind, vor- oder nachgeschaltet befindet;

 **dadurch gekennzeichnet, dass** der Schritt der Verarbeitung der Signale Folgendes aufweist:

 - die Berechnung der Veränderung des Nullstroms ($I_0$) von jedem der Phasenströme ($I_A$, $I_B$, $I_C$) über die vorbestimmte Dauer ($T_{acq}$) in Bezug zu den gespeicherten Werten ($I_{0\_MEM}$, $I_{A\_MEM}$, $I_{B\_MEM}$, $I_{C\_MEM}$);
 - die Berechnung der normalisierten Korrelationskoeffizienten ($r_A$, $r_B$, $r_C$) zwischen den Schwankungen der Signale des Nullstroms ($\Delta I_0$) und von jedem der Phasenströme ($\Delta I_A$, $\Delta I_B$, $\Delta I_C$) über die vorbestimmte Dauer ($T_{acq}$);
 - die Berechnung des arithmetischen Mittels ($\mu$) und der Standardabweichung ($\sigma$) der Korrelationskoeffizienten ($r_A$, $r_B$, $r_C$);
 - wobei die Interpretation durch einen Vergleich unter Verwendung des Mittels ($\mu$) und der Standardabweichung ($\sigma$) ausgeführt wird.

9. Verfahren zur Richtungserkennung nach Anspruch 8, wobei die Speicherung der charakteristischen Werte ($I_{0\_MEM}$, $I_{A\_MEM}$, $I_{B\_MEM}$, $I_{C\_MEM}$) auf gleitende Weise erhalten wird, solange das Signal, das das Vorhandensein des Erdschlusses (D) anzeigt, nicht erhalten wird.

10. Verfahren zur Richtungserkennung nach Anspruch 8 oder 9, wobei das Signal (D), das das Vorhandensein eines Erdschlusses (7) anzeigt, durch den Empfang eines Signals, das für den Nullstrom ($I_0$) charakteristisch ist, der in dem Netz (1) fließt, und das Ergebnis eines Vergleichs des Nullstromsignals ($I_0$) mit einer Erdschluss-Erkennungsschwelle ($S_0$) erhalten wird.

11. Verfahren zur Richtungserkennung nach einem der Ansprüche 8 bis 10, wobei der Interpretationsschritt den Vergleich der Differenz zwischen dem Quadrat des Dreifachen der Standardabweichung ($\sigma$) und dem Achtfachen des Quadrates des Mittels ($\mu$) mit Null aufweist.

12. Verfahren zur Richtungserkennung nach einem der Ansprüche 8 bis 10, wobei der Schritt der Interpretation den grafischen Vergleich des Mittels ($\mu$) und der Standardabweichung ($\sigma$) mit zwei Halbgeraden der Gleichung

$$y = \left| \frac{2\sqrt{2}}{3} . x \right| \quad \text{aufweist.}$$

13. Verfahren zur Richtungserkennung nach einem der Ansprüche 8 bis 12, wobei der Schritt der Lieferung der Signale, die für die Phasenströme ($I_A$, $I_B$, $I_C$) charakteristisch sind, eine Abtastung des Stroms mit einer Frequenz von über 1,5 kHz aufweist.

14. Verfahren zur Richtungserkennung nach einem der Ansprüche 8 bis 13, wobei die Berechnung von normalisierten Korrelationskoeffizienten ($r_A$, $r_B$, $r_C$) gemäß der Bravais-Pearson-Formel ausgeführt wird.

**15.** Verfahren zum Schutz einer Stromleitung (5) beim Auftreten eines Erdschlusses (7), das die Betätigung einer Abschaltvorrichtung (6) der Leitung (5) aufweist, wenn ein Erdschluss (7) durch ein Verfahren nach einem der Ansprüche 8 bis 14 der Abschaltvorrichtung (6) nachgelagert erkannt wurde.

**Claims**

**1.** Device (10) for directional detection of an earth fault (7) in a multiphase network comprising:

- first means (14) for receiving signals representative of the current ($I_A$, $I_B$, $I_C$) of each of the phases;
- second means (14') for receiving a signal representative of the homopolar current ($I_0$) of all the phases;
- processing means (30) for processing the signals representative of current, comprising means (34) for calculating normalized correlation coefficients ($r_A$, $r_B$, $r_C$) and means (36) for calculating the mean ($\mu$) and standard deviation ($\sigma$) of the calculated correlation coefficients;
- means for activating said processing means (30) depending on a detection signal (D) of the occurrence of an earth fault in the network (I);
- means for interpreting results of the processing of the signals comprising means for comparing said mean ($\mu$) and said standard deviation ($\sigma$) in order to determine whether the fault is upstream or downstream of the device (10);

**characterized in that** the device (10) furthermore comprises storage means (20) for storing values of the signals representative of the homopolar current and of the current of each of the phases ($I_{0\_MEM}$, $I_{A\_MEM}$, $I_{B\_MEM}$, $I_{C\_MEM}$) over a storage duration ($T_{acq}$) prior to the detection signal (D) of the occurrence of an earth fault (7), and the processing means (30) comprise means for determining the variation of the signal representative of the homopolar current and of the current of each of the phases ($\Delta I_0$, $\Delta I_A$, $\Delta I_B$, $\Delta I_C$) with respect to the stored values ($I_{0\_MEM}$, $I_{A\_MEM}$, $I_{B\_MEM}$, $I_{C\_MEM}$) over a predetermined duration smaller than or equal to the storage duration, the means for calculating normalized correlation coefficients (34) being suitable for calculating correlation coefficients ($r_A$, $r_B$, $r_C$) between the variation of the signal representative of the homopolar current ($\Delta I_0$) and the variation of each of the signals representative of the phase current ($\Delta I_A$, $\Delta I_B$, $\Delta I_C$).

**2.** Directional detection device (10) according to Claim 1, in which the storage duration corresponds to a whole number of periods of the network (1) and the determined duration is equal to the duration of storage ($T_{acq}$).

**3.** Detection device according to either of Claims 1 and 2, in which the storage means (20) are suitable for storing the values over a rolling period and comprise means for deactivating depending on a detection signal (D) of the occurrence of an earth fault in the network (1).

**4.** Directional detection device (10) according to one of Claims 1 to 3, furthermore comprising means (18) for detecting the occurrence of an earth fault in the network, which means are linked to the means for activating the processing means (30) and to the storage means (20), comprising a comparator for comparing the signal representative of the homopolar current ($I_0$) with a threshold of detection ($S_0$).

**5.** Directional detection device **(10)** according to one of Claims 1 to 4, in which the first means (14) for receiving signals representative of the currents of each phase ($I_A$, $I_B$, $I_C$) comprise sampling means (18) suitable for supplying a sufficient number of values over the predetermined duration and the storage duration ($T_{acq}$).

**6.** Earth-fault occurrence indicator comprising current sensors ($12_A$, $12_B$, $12_C$) arranged on each phase conductor ($5_A$, $5_B$, $5_C$) of an electrical network (1) to be monitored and comprising a device for directional fault detection (10) according to one of Claims 1 to 5, connected to said current sensors ($12_A$, $12_B$, $12_C$) for receiving the signals representative of phase current ($I_A$, $I_B$, $I_C$).

**7.** Earth protection relay (9) comprising at least one fault indicator according to Claim 6 and means for actuating a switching device (6) depending on the results of the interpreting means (40) of the directional detection device (10) of the indicator.

**8.** Method for directional detection (D, L) of an earth fault (7) in a multiphase network (1) in which signals representative of the homopolar current ($I_{0\_MEM}$) and of each of the phase currents ($I_{A\_MEM}$, $I_{B\_MEM}$, $I_{C\_MEM}$) are memorized over a duration ($T_{acq}$) of at least one period of the network, comprising the triggering, following the obtention of a signal (D) indicative of the presence of said earth fault (10), of the directional determination (L) of the fault (10), said directional determination comprising the successive steps of:

- obtaining signals representative of each of the phase currents ($I_A$, $I_B$, $I_C$) over a predetermined duration ($T_{acq}$) shorter than or equal to the duration of memorization;
- obtaining a signal representative of the homopolar current ($I_0$) flowing in the network over the same predetermined duration ($T_{acq}$);
- processing the signals representative of the phase currents and the earth fault current ($I_0$, $I_A$, $I_B$, $I_C$);
- interpreting the results of the processing of the signals in order to indicate whether the detected fault (D) is situated upstream or downstream of the location at which the signals representative of the phase currents ($I_A$, $I_B$, $I_C$) were obtained;

**characterized in that** said step of processing the signals comprises:

- calculating the variation of the homopolar current ($I_0$) and of each of the phase currents ($I_A$, $I_B$, $I_C$) over the predetermined duration ($T_{acq}$) with respect to the memorized values ($I_{0\_MEM}$, $I_{A\_MEM}$, $I_{B\_MEM}$, $I_{C\_MEM}$);
- calculating the normalized correlation coefficients ($r_A$, $r_B$, $r_C$) between the variations of the homopolar current signal ($\Delta I_0$) and of each of the phase current signals ($\Delta I_A$, $\Delta I_B$, $\Delta I_C$) over the predetermined duration ($T_{acq}$);
- calculating the arithmetic mean ($\mu$) and the standard deviation ($\sigma$) of said correlation coefficients ($r_A$, $r_B$, $r_C$);
- said interpretation being carried out by a comparison employing said mean ($\mu$) and said standard deviation ($\sigma$).

9. Directional detection method according to Claim 8, in which the representative values ($I_{0\_MEM}$, $I_{A\_MEM}$, $I_{B\_MEM}$, $I_{C\_MEM}$) are memorized in a rolling manner as long as the signal indicative of the presence of the fault (D) is not obtained.

10. Directional detection method according to Claim 8 or 9, in which the signal (D) indicative of the presence of an earth fault (7) is obtained via the reception of a signal representative of the homopolar current ($I_0$) flowing in the network (1) and the result of a comparison of the homopolar current signal ($I_0$) with a fault detection threshold ($S_0$).

11. Directional detection method according to one of Claims 8 to 10, in which the interpretation step comprises comparing, with zero, the difference between the square of three times the standard deviation ($\sigma$) and eight times the square of the mean ($\mu$).

12. Directional detection method according to one of Claims 8 to 10, in which the interpretation step comprises graphical comparison of the mean ($\mu$) and standard deviation ($\sigma$) with two half-lines of equation $y = \left| \dfrac{2\sqrt{2}}{3} \cdot x \right|$.

13. Directional detection method according to one of Claims 8 to 12, in which the step for providing the signals representative of the phase currents ($I_A$, $I_B$, $I_C$) comprises sampling the current at a frequency higher than 1.5 kHz.

14. Directional detection method according to one of Claims 8 to 13, in which the normalized correlation coefficients ($r_A$, $r_B$, $r_C$) are calculated according to the Bravais-Pearson formula.

15. Method for protecting a power line (5) during the occurrence of an earth fault (7) comprising actuating a breaking device (6) of said line (5) if an earth fault (7) has been detected by a method according one of Claims 8 to 14 downstream of said breaking device (6).

**Fig. 1**

**Fig.2**

Début

$I_A$, $I_B$, $I_C$

$I_{Af}$, $I_{Bf}$, $I_{Cf}$

$I_{Af}^*$, $I_{Bf}^*$, $I_{Cf}^*$

$I_0$

$I_0 > S_0$ ?

$I_{A\_MEM}$, $I_{B\_MEM}$, $I_{C\_MEM}$, $I_{0\_MEM}$

$T_{acq}$

D

$\Delta I_{Af}^*$, $\Delta I_{Bf}^*$, $\Delta I_{Cf}^*$, $\Delta I_0$

$T_{acq}$

Calcul corrélation :  $r_A \rightarrow \Delta I_0, \Delta I_{Af}^*$
$r_B \rightarrow \Delta I_0, \Delta I_{Bf}^*$
$r_C \rightarrow \Delta I_0, \Delta I_{Cf}^*$

$\mu$ = moyenne ($r_A$, $r_B$, $r_C$)
$\sigma$ = écart-type ($r_A$, $r_B$, $r_C$)

$\sigma > |\mu| \cdot 2 \cdot \sqrt{2} / 3$ ?

L

L

Défaut en AMONT

Défaut en AVAL

Ouverture du disjoncteur 6
par le relai 9

Fig.3

**Fig.4**

EP 2 687 860 B1

**EP 2 687 860 B1**

**Documents brevets cités dans la description**

- FR 2936319
- EP 1603211 A
- EP 2533060 A